# EUROPEAN PATENT APPLICATION

(11) **EP 2 787 547 A1**
(43) Date of publication of application: **08.10.2014**
(21) Application number: 11876558.5
(22) Date of filing: 28.11.2011
(51) Int. Cl.: H01L 51/46, H01L 51/42

(54) **POLYMER SOLAR CELL AND METHOD FOR PREPARING SAME**

(71) Applicant: Ocean's King Lighting Science & Technology Co., Ltd., Nanhai Rd., Nanshan Shenzhen, Guangdong 518054 (CN); Shenzhen Ocean's King Lighting Engineering Co. Ltd., Guangdong 518100 (CN)
(72) Inventor: ZHOU, Mingjie, Shenzhen Guangdong 518054 (CN); WANG, Ping, Shenzhen Guangdong 518054 (CN); HUANG, Hui, Shenzhen Guangdong 518054 (CN); ZHANG, Zhenhua, Shenzhen Guangdong 518054 (CN)
(74) Representative: Cabinet Laurent & Charras
(86) International application number: PCT/CN2011/083013
(87) International publication number: WO 2013/078580

(57) **Abstract**

The present invention relates to a polymer solar cell and a method for preparing the same. The cell comprises a conductive anode substrate, a hole buffer layer, an active polymer layer, an electron buffer layer and a cathode laminated in succession, wherein the hole buffer layer comprises a metal compound host and a guest doped in the metal compound host, the metal compound host being one selected from ZnO, ZnS and CdS and the doped gust being one selected from Li2CO3, Li₂O, LiF, LiCl and LiBr. By doping a lithium compound with few electrons as a dopant into the metal compound host, a p-type doped layer facilitating the hole transportation is formed in the polymer solar cell. The dopant and the metal compound host have stable properties and would not corrode the conductive anode substrate, facilitating industrial production in the future and effectively improving the energy conversion efficiency of the polymer solar cell.

## Description

### FIELD OF THE INVENTION

The present disclosure relates to a field of solar cell, and more particularly relates to a polymer solar cell and a method for preparing the same.

### BACKGROUND OF THE INVENTION

In 1982, Weinberger et al. researched the photovoltaic properties of polyacetylene and prepared the first true sense of solar cell. Subsequently, Glenis et al. prepared a variety of solar cells of polythiophene. These solar cells had problems of very low open circuit voltage and photoelectric conversion efficiency. Until 1986, C.W.Tang et al. introduced the p-type semiconductor and the n-type semiconductor into devices of bilayer structure for the first time, the level of the photocurrent had been improved greatly, and the organic polymer solar cells had flourished since this work which is regarded as a milestone.

In 1992, Sariciftci et al. found that there was a phenomenon of rapid light-induced electron transfer in the composite system of 2 - methoxy-5 - (2 - ethyl - hexyloxy) -1,4 - styrene (MEH-PPV) and C₆₀, which aroused great interest. In 1995, Yu et al. prepared an organic polymer bulk-heterojunction solar cell by mixing MEH-PPV and C₆₀ derivatives PCBM as an active layer. The energy conversion efficiency of the device was 2.9% under the monochromatic light of 20mW/cm² 430nm, this was the first bulk-heterojunction solar cell based on polymer materials and PCBM acceptor, and the concept of composite membrane interpenetrating with network structure was proposed. So far the application of the bulk-heterojunction structure in the polymer solar cell has been rapidly developed; this structure has been widely used in the organic polymer solar cell currently.

The working principle of the polymer solar cell includes mainly four parts: (1) the formation of light excitation and excitons; (2) the diffusion of the excitons; (3) the splitting of the excitons; (4) the transmission and collection of the charges. First, the conjugated polymer absorbs photons under the incident light, the electrons transit from the highest occupied orbital (HOMO) to the lowest empty track (LUMO) to form the excitons; the excitons diffuse to the intersurface of the donor/ acceptor under the influence of the built-in electric field and separate into free electrons and holes, and the electrons transfer in the receptor and are collected by the cathode, the holes are collected by the anode via the donor, thereby generating photocurrent.

The conventional hole buffer material used in the solar cell is aqueous mixture of poly 3, 4 - ethylene dioxythiophene (PEDOT) and poly (styrene sulfonate) (PSS). When the aqueous mixture is spin-coated on the anode substrate, since the aqueous mixture is acidic, ITO will be corroded, thereby affecting the service life of the device.

### SUMMARY OF THE INVENTION

Accordingly to this, the present disclosure is directed to provide a polymer solar cell with a better corrosion resistance and a method for preparing the polymer with a better corrosion resistance.

A polymer solar cell includes an anode conductive substrate, a hole buffer layer, an active polymer layer, an electron buffer layer, and a cathode, which are laminated in that order. The hole buffer layer includes a metal compound host and a dopant guest doped in the metal compound host. The metal compound host is made of a material selected from the group consisting of ZnO, ZnS, and CdS. The dopant guest is made of a material selected from the group consisting of Li₂CO₃, Li₂O, LiF, LiCl, and LiBr. A mass ratio of the dopant guest in the metal compound host is in the range of from 1% to 10%.

In a preferred embodiment, a thickness of the hole buffer layer is in the range of from 20nm to 100nm.

In a preferred embodiment, the anode conductive substrate is made of a material selected from the group consisting of indium tin oxide glass, fluorine-doped tin oxide glass, aluminum-doped zinc oxide glass, and indium-doped zinc oxide glass.

In a preferred embodiment, the active polymer layer is made of a material selected from the group consisting of a mixture of P3HT and PCBM, a mixture of MODO-PPV and PCBM, and a mixture of MEH-PPV and PCBM; a mass ratio of the P3HT to the PCBM in the mixture of P3HT and PCBM is in the range of from 1:0.8 to 1:1, a mass ratio of the MODO-PPV to the PCBM in the mixture of MODO-PPV and PCBM is in the range of from 1:1 to 1:4, a mass ratio of the MEH-PPV to the PCBM in the mixture of MEH-PPV to PCBM is in the range of from 1:1 to 1:4; a thickness of the active polymer layer is in the range of from 80nm to 300nm.

In a preferred embodiment, the electron buffer layer is made of a material selected from the group consisting of lithium fluoride, cesium fluoride, and cesium carbonate; a thickness of the electron buffer layer is in the range of from 0.5nm to 10nm.

In a preferred embodiment, the cathode is made of a material selected from the group consisting of aluminum, silver, gold, and platinum; a thickness of the cathode is in the range of from 80nm to 250nm.

A method of preparing a polymer solar cell includes steps of:

photoetching an anode conductive substrate, and cleaning the anode conductive substrate to remove impurities on a surface thereof;

forming a hole buffer layer on the photoetched anode conductive by an electron beam technology or a sputtering process, wherein a metal compound is used as a host, a lithium compound is used as a dopant guest, a mass ratio of the dopant guest in the host is in the range of from 1% to 10%; and the metal compound host is made of a material selected from the group consisting of ZnO, ZnS, and CdS; the dopant guest is made of a material selected from the group consisting of Li₂CO₃, Li₂O, LiF, LiCl, and LiBr; and

forming an active polymer layer, an electron buffer layer, and a cathode on the hole buffer layer, sequentially.

In a preferred embodiment, the method further includes:
performing a surface treatment to the cleaned anode conductive substrate using oxygen plasma or UV-ozone.

In a preferred embodiment, forming the active polymer layer on the hole buffer layer includes:
coating a polymer solution on the hole buffer layer by spin-coating;
drying the polymer solution to form the active polymer layer; a solute of the polymer solution is selected from the group consisting of a mixture of P3HT and PCBM, a mixture of MODO-PPV and PCBM, and a mixture of MEH-PPV and PCBM; a mass ratio of the P3HT to the PCBM in the mixture of P3HT and PCBM is in the range of from 1:0.8 to 1:1, a mass ratio of the MODO-PPV to the PCBM in the mixture of MODO-PPV and PCBM is in the range of from 1:1 to 1:4, a mass ratio of the MEH-PPV to the PCBM in the mixture of MEH-PPV and PCBM is in the range of from 1:1 to 1:4; a solvent of the polymer solution is selected from the group consisting of toluene, xylene, chlorobenzene, and chloroform; a concentration of the solute in the polymer solution is in the range of from 8mg/mL to 30mg/mL.

In a preferred embodiment, forming the electron buffer layer on the active polymer layer includes: depositing a material selected from the group consisting of lithium fluoride, cesium fluoride, and cesium carbonate on the active polymer layer by a magnetron sputtering process or an evaporation process; and

Forming the cathode on the electron buffer layer includes: depositing a material selected from the group consisting of aluminum, silver, gold, and platinum on the electron buffer layer by a magnetron sputtering process or an evaporation process.

In the polymer solar cell, the lithium compound with less electrons is doped into the metal compound host as a dopant guest, which helps to form a p-type doped layer conducive to the hole transport. The dopant guest and the metal compound host are stable, inexpensive, have a simple doping process, its raw materials are readily available, and do not corrode the anode conductive substrate, which is conducive to the industrial production. Furthermore, the doping of the p-type doped layer is conducive to the hole transport, thus the hole transmission rate is increased. Further still, the collection hole rate of the anode conductive substrate is improved, thereby improving the energy conversion efficiency of the polymer solar cell.

### BRIEF DESCRIPTION OF THE DRAWINGS

FIG. 1 is a schematic, cross-sectional view of an embodiment of a polymer solar cell;
FIG. 2 is a flow chart of an embodiment of a method for preparing a polymer solar cell;
FIG. 3 is a graph illustrating a relationship of current density and voltage between the conventional polymer solar cell and the polymer solar cell of Example 1.

### DETAILED DESCRIPTION OF THE EMBODIMENTS

A more particular description of the polymer solar cell and a method for preparing the polymer solar cell will be illustrated by reference to specific embodiments and drawings.

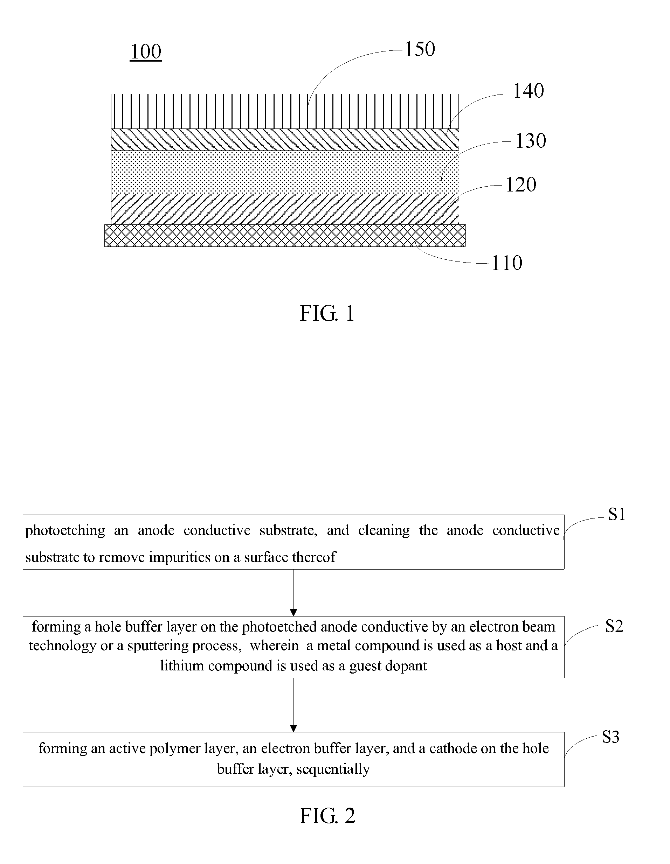

Referring to FIG. 1, an embodiment of a polymer solar cell 100 includes an anode conductive substrate 110, a hole buffer layer 120, an active polymer layer 130, an electron buffer layer 140, and a cathode 150, which are laminated in that order.

The anode conductive substrate 110 is made of a material selected from the group consisting of indium tin oxide glass (ITO), fluorine-doped tin oxide glass (FTO), aluminum-doped zinc oxide glass (AZO), and indium-doped zinc oxide glass (IZO).

The hole buffer layer 120 includes a metal compound host and a dopant guest doped in the metal compound host. The metal compound host is made of a material selected from the group consisting of zinc oxide (ZnO), zinc sulfide (ZnS), and cadmium sulfide (CdS). The dopant guest is made of a material selected from the group consisting of lithium carbonate (Li₂CO₃), lithium oxide (Li₂O), lithium fluoride (LiF), lithium chloride (LiCl), and lithium bromide (LiBr). Amass ratio of the dopant guest in the metal compound host is in the range of from 1% to 10%. Furthermore, preferably, a thickness of the hole buffer layer 120 is in the range of from 20nm to 100nm.

Preferably, the active polymer layer 130 is made of a material selected from the group consisting of a mixture of P3HT and PCBM, a mixture of MODO-PPV and PCBM, and a mixture of MEH-PPV and PCBM. A mass ratio of the P3HT to the PCBM in the mixture of P3HT and PCBM is in the range of from 1:0.8 to 1:1. Amass ratio of the MODO-PPV to the PCBM in the mixture of MODO-PPV and PCBM is in the range of from 1:1 to 1:4. Amass ratio of the MEH-PPV to the PCBM in the mixture of MEH-PPV and PCBM is in the range of from 1:1 to 1:4. Preferably, the thickness of the active polymer layer 130 is in the range of from 80nm to 300nm. Furthermore, preferably, the active polymer layer 130 is made of the mixture of P3HT and PCBM, the mass ratio of the P3HT to the PCBM equals to 1: 0.8, the thickness of the active polymer layer 130 is 120nm.

The electron buffer layer 140 is made of a material selected from the group consisting of lithium fluoride (LiF), cesium fluoride (CsF), and cesium carbonate (Cs₂CO₃). A thickness of the electron buffer layer 140 is in the range of from 0.5nm to 10nm.

The cathode 150 is made of a material selected from the group consisting of aluminum (Al), silver (Ag), gold (Au), and platinum (Pt). Preferably, a thickness of the cathode is in the range of from 80nm to 250nm.

In the polymer solar cell 100, the lithium compound with less electrons is doped into the metal compound host as a dopant guest, which helps to form a p-type doped layer conducive to the hole transport. The dopant guest and the metal compound host are stable, inexpensive, have a simple doping process, its raw materials are readily available, and do not corrode the anode conductive substrate 110, which is conducive to the industrial production. Furthermore, the doping of the p-type doped layer is conducive to the hole transport, thus the hole transmission rate is increased. Further still, the collection hole rate of the anode conductive substrate is improved, thereby improving the energy conversion efficiency of the polymer solar cell 100 ultimately.

Referring to FIG. 2, an embodiment of a method for preparing a polymer solar cell is provided, which includes the steps of:

Step S1, an anode conductive substrate is photoetched, and then cleaned to remove impurities on the anode conductive substrate surface.

The anode conductive substrate is photoetched and cut into pieces with required size. The anode conductive substrate is then treated using ultrasonic sequentially in detergent, deionized water, acetone, ethanol, and isopropyl alcohol each for 15 minutes to remove impurities on the substrate surface.

In a preferred embodiment, after the step S1, the anode conductive substrate is surface-treated using oxygen plasma or UV-ozone. The oxygen plasma treatment can be performed for 5 minutes to 15 minutes, the power is 10W to 50W; the UV-ozone treatment can be performed for 5 minutes to 20 minutes; thus the anode conductive substrate is surface-modified to increase bonding to subsequent layers.

Step S2, a hole buffer layer is formed on the photoetched anode conductive by an electron beam technology or a sputtering process. In the hole buffer layer, a metal compound is used as a host, a lithium compound is used as a dopant guest; a mass ratio of the dopant guest in the host is in the range of from 1% to 10%.

The metal compound host is made of a material selected from the group consisting of ZnO,ZnS, and CdS. The lithium compound is made of a material selected from the group consisting of Li₂CO₃, Li₂O, LiF, LiCl, and LiBr. The thickness of the hole buffer layer is in the range of from 20nm to 100nm.

Step S3, an active polymer layer, an electron buffer layer, and a cathode are formed on the hole buffer layer, sequentially.

Forming the active polymer layer on the hole buffer layer includes: a polymer solution is coated on the hole buffer layer by spin-coating; then the polymer solution is dried to form the active polymer layer. The thickness of the active polymer layer is in the range of from 80nm to 300nm. Preferably, the thickness of the active polymer layer is 120nm.

A solute of the polymer solution is selected from the group consisting of a mixture of P3HT and PCBM, a mixture of MODO-PPV and PCBM, and a mixture of MEH-PPV and PCBM. A mass ratio of the P3HT to the PCBM in the mixture of P3HT and PCBM is in the range of from 1:0.8 to 1:1. A mass ratio of the MODO-PPV to the PCBM in the mixture of MODO-PPV and PCBM is in the range of from 1:1 to 1:4. A mass ratio of the MEH-PPV to the PCBM in the mixture of MEH-PPV and PCBM is in the range of from 1:1 to 1:4. A solvent of the polymer solution is selected from the group consisting of toluene, xylene, chlorobenzene, and chloroform. A concentration of the solute in the polymer solution is in the range of from 8mg/mL to 30mg/mL. Preferably, the polymer solution is chlorobenzene solution of the mixture of P3HT and PCBM, the mass ratio of the P3HT to PCBM equals to 1: 0.8, the concentration of the solute is 24mg/mL.

The polymer solution can be annealed at a temperature from 50°C to 200°C for 5 to minutes 100 minutes, or it can be dried at a room temperature for 24 hours to 48 hours. Preferably, it can be annealed at temperature of 100°C for 30 min.

Forming the electron buffer layer on the active polymer layer includes: a material selected from the group consisting of lithium fluoride, cesium fluoride, and cesium carbonate is deposited on the active polymer layer by a magnetron sputtering process or an evaporation process. Preferably, the electron buffer layer is formed by evaporation process. The thickness of the electron buffer layer is in the range of from 0.5nm to 10nm. For example, a layer of lithium fluoride with a thickness of 0.7nm can be deposited on the active polymer layer by evaporation process.

Forming the cathode on the electron buffer layer includes: a material selected from the group consisting of aluminum, silver, gold, and platinum is deposited on the electron buffer layer by a magnetron sputtering process or an evaporation process. Preferably, the cathode is formed by evaporation process. The thickness of the cathode is in the range of from 80nm to 250nm. For example, a layer of aluminum with a thickness of 150nm can be deposited by evaporation process to form the cathode.

The preparion process can be widely applied for its simple process and readily available raw materials.

The specific examples are described as follows:

The test instruments used in each example are: high vacuum coating equipment (Shenyang scientific instruments Center Ltd. pressure<1×10⁻³Pa), current-voltage tester (U.S. Keithly Corporation, Model: 2602), 500W xenon lamp (Osram) combined with filter of AM 1.5 are used as white - light source for simulating sunlight.

### EXAMPLE 1

The polymer solar cell has a structure of ITO/ZnO:Li₂CO₃/ P3HT:PCBM/LiF/Al.

The preparation process is described as follows:

The ITO was photoetched and cut into pieces with required size, the anode conductive substrate was then treated using ultrasonic sequentially in detergent, deionized water, acetone, ethanol, and isopropyl alcohol each for 15 minutes to remove impurities on the surface of the ITO, respectively. The conductive substrate was surface-treated using oxygen plasma for 5 minutes after cleaning; the power was 10W.

The hole buffer layer with a thickness of 60nm was formed on the surface of the ITO by electron beam technology, in which, ZnO was used as a host and Li₂CO₃ was used as a dopant guest, a mass ratio of Li₂CO₃ to ZnO was 6%.

The chlorobenzene solution of the mixture of P3HT and PCBM was then spin-coated on the hole buffer layer, and dried at a temperature of 100°C for 30 minutes to form the active polymer layer with a thickness of 120nm. The mass ratio of the P3HT to the PCBM equaled to 1:0.8, the solute concentration was 24 mg/mL.

The LiF with a thickness of 0.7nm was deposited on the active polymer layer by evaporation process.

The Al with a thickness of 150nm was deposited as the cathode by evaporation process, and the polymer solar cell was formed.

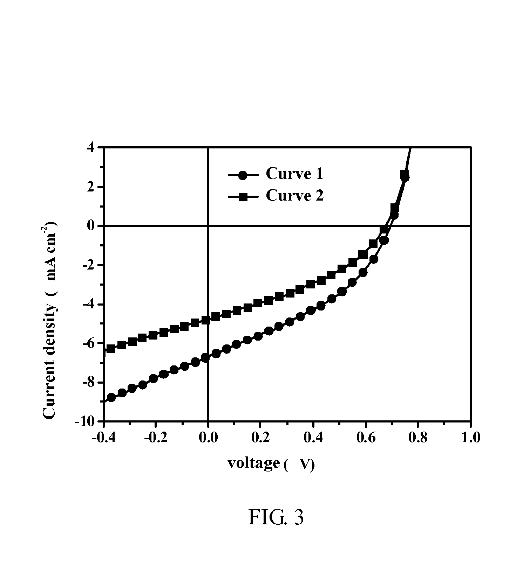

FIG. 3 is a graph illustrating a relationship of current density and voltage between the conventional polymer solar cell of ITO/ZnO:Li₂CO₃/P3HT: PCBM/LiF/Al (curve 1) and the polymer solar cell of ITO/PEDOT:PSS/P3HT:PCBM/LiF/Al (curve 2) of example one. The results are shown in Table 1.

**Table 1**

| | Current density (mA cm⁻²) | voltage (V) | η (%) | fill factor |
|---|---|---|---|---|
| Curve 1 | 6.67 | 0.69 | 1.75 | 0.38 |
| Curve 2 | 4.78 | 0.67 | 1.19 | 0.37 |

It can be seen from FIG. 3 that, the current density of the conventional polymer solar cell is 4.78 mA/cm², while the current density of the polymer solar cell of Example one is increased to 6.67 mA/cm². The results illustrate that the hole transmission rate is effectively improved by doping the lithium compounds into the metal compound host; thus more holes are collected by the anode, and the energy conversion efficiency of the polymer solar cell is finally enhanced. The energy conversion efficiency of conventional polymer solar cell is 1.19%, while the energy conversion efficiency of the polymer solar cell of Example one is 1.75%.

The luminescent spectrums of the following examples are similar to that of Example one, the luminescent elements also have similar luminescent intensity, which will not be described in details.

### EXAMPLE 2

The polymer solar cell has a structure of IZO/ZnS:Li₂O/ MEH-PPV:PCBM/CsF/Ag.

The preparation process is described as follows:

The IZO was photoetched and cut into pieces with required size, the anode conductive substrate was then treated using ultrasonic sequentially in detergent, deionized water, acetone, ethanol, and isopropyl alcohol each for 15 minutes to remove impurities on the surface of the IZO, respectively. The conductive substrate was surface-treated using oxygen plasma for 10 minutes after cleaning; the power was 50W.

The hole buffer layer with a thickness of 100nm was formed on the surface of the IZO by magnetron sputtering process, in which, ZnS was used as a host and Li₂O was used as a dopant guest, a mass ratio of Li₂O to ZnS was 10%.

The xylene solution of the mixture of MEH-PPV and PCBM was then spin-coated on the hole buffer layer, and dried at a temperature of 70°C for 100 minutes to form the active polymer layer with a thickness of 300nm. The mass ratio of the MEH-PPV to the PCBM equaled to 1:4, the solute concentration was 30 mg/mL.

The CsF with a thickness of 10nm was deposited on the active polymer layer by evaporation process.

The Ag with a thickness of 80nm was deposited as the cathode by evaporation process, and the polymer solar cell was formed.

### EXAMPLE 3

The polymer solar cell has a structure of FTO/CdS:LiCl/ MDMO-PPV:PCBM/LiF/Au.

The preparation process is described as follows:

The FTO was photoetched and cut into pieces with required size, and the anode conductive substrate was then treated using ultrasonic sequentially in detergent, deionized water, acetone, ethanol, and isopropyl alcohol each for 15 minutes to remove impurities on the surface of the FTO, respectively. The conductive substrate was surface-treated using oxygen plasma for 15 minutes after cleaning; the power was 30W.

The hole buffer layer with a thickness of 10nm was formed on the surface of the FTO by electron beam technology, in which, CdS was used as a host and LiCl was used as a dopant guest, a mass ratio of LiCl to CdS was 1%.

The chlorobenzene solution of the mixture of MDMO-PPV and PCBM was spin-coated on the hole buffer layer, and dried at a temperature of 200°C for 10 minutes to form the active polymer layer with a thickness of 1500nm. The mass ratio of the MDMO-PPV to the PCBM equaled to 1:3, the solute concentration was 8 mg/mL.

The LiF with a thickness of 0.5nm was deposited on the active polymer layer by evaporation process.

The Au with a thickness of 250nm was deposited as the cathode by evaporation process, and the polymer solar cell was formed.

### EXAMPLE 4

The polymer solar cell has a structure of AZO/ZnS:LiBr /P3HT:PCBM/CsF/Ag.

The preparation process is described as follows:

The AZO was photoetched and cut into pieces with required size, the anode conductive substrate was then treated using ultrasonic sequentially in detergent, deionized water, acetone, ethanol, and isopropyl alcohol each for 15 minutes to remove impurities on the surface of the FTO, respectively. The conductive substrate was surface-treated using oxygen plasma for 8 minutes after cleaning; the power was 40W.

The hole buffer layer with a thickness of 80nm was formed on the surface of the AZO by magnetron sputtering process, in which, ZnS was used as a host and LiBr is used as a dopant guest, a mass ratio of LiBr to ZnS was 5%.

The chlorobenzene solution of the mixture of P3HT and PCBM was then spin-coated on the hole buffer layer, and dried at a room temperature for 24 hours to form the active polymer layer with a thickness of 80nm. The mass ratio of the P3HT to the PCBM equaled to 1:3, the solute concentration was 18 mg/mL.

The CsF with a thickness of 10nm was deposited on the active polymer layer by evaporation process.

The Ag with a thickness of 80nm was deposited as the cathode by evaporation process, and the polymer solar cell is formed.

### EXAMPLE 5

The polymer solar cell has a structure of ITO/ZnO:LiF/ MDMO-PPV:PCBM/CsF/Al.

The preparation process is described as follows:

The ITO was photoetched and cut into pieces with required size, and the anode conductive substrate was then treated using ultrasonic sequentially in detergent, deionized water, acetone, ethanol, and isopropyl alcohol each for 15 minutes to remove impurities on the surface of the ITO, respectively. The conductive substrate was surface-treated using oxygen plasma for 12 minutes after cleaning; the power was 20W.

The hole buffer layer with a thickness of 90nm was formed on the surface of the ITO by electron beam technology, in which, ZnO was used as a host and LiF was used as a dopant guest, a mass ratio of LiF to ZnO was 7%.

The chlorobenzene solution of the mixture of MDMO-PPV and PCBM was spin-coated on the hole buffer layer, and dried at a temperature of 100°C for 30 minutes to form the active polymer layer with a thickness of 100nm. The mass ratio of the MDMO-PPV to the PCBM equaled to 1:2, the solute concentration was 20 mg/mL.

The CsF with a thickness of 10nm was deposited on the active polymer layer by evaporation process.

The Al with a thickness of 200nm was deposited as the cathode by evaporation process, and the polymer solar cell was formed.

Although the invention has been described in language specific to structural features and/or methodological acts, it is to be understood that the invention defined in the appended claims is not necessarily limited to the specific features or acts described. Rather, the specific features and acts are disclosed as sample forms of implementing the claimed invention.

## Claims

1. A polymer solar cell, comprising an anode conductive substrate, a hole buffer layer, an active polymer layer, an electron buffer layer, and a cathode, which are laminated in that order;
wherein the hole buffer layer comprises a metal compound host and a dopant guest doped in the metal compound host; the metal compound host is made of a material selected from the group consisting of zinc oxide, zinc sulfide, and cadmium sulfide; the dopant guest is made of a material selected from the group consisting of lithium carbonate, lithium oxide, lithium fluoride, lithium chloride, and lithium bromide;
wherein a mass ratio of the dopant guest in the metal compound host is in the range of from 1% to 10%.

2. The polymer solar cell according to claim 1, wherein a thickness of the hole buffer layer is in the range of from 20nm to 100nm.

3. The polymer solar cell according to claim 1 or 2, wherein the anode conductive substrate is made of a material selected from the group consisting of indium tin oxide glass, fluorine-doped tin oxide glass, aluminum-doped zinc oxide glass, and indium-doped zinc oxide glass.

4. The polymer solar cell according to claim 1 or 2, wherein the active polymer layer is made of a material selected from the group consisting of a mixture of P3HT and PCBM, a mixture of MODO-PPV and PCBM, and a mixture of MEH-PPV and PCBM; a mass ratio of the P3HT to the PCBM in the mixture of P3HT and PCBM is in the range of from 1:0.8 to 1:1, a mass ratio of the MODO-PPV to the PCBM in the mixture of MODO-PPV and PCBM is in the range of from 1:1 to 1:4, a mass ratio of the MEH-PPV to the PCBM in the mixture of MEH-PPV and PCBM is in the range of from 1:1 to 1:4, a thickness of the active polymer layer is in the range of from 80nm to 300nm.

5. The polymer solar cell according to claim 1 or 2, wherein the electron buffer layer is made of a material selected from the group consisting of lithium fluoride, cesium fluoride, and cesium carbonate; a thickness of the electron buffer layer is in the range of from 0.5nm to 10nm.

6. The polymer solar cell according to claim 1 or 2, wherein the cathode is made of a material selected from the group consisting of aluminum, silver, gold, and platinum; a thickness of the cathode is in the range of from 80nm to 250nm.

7. A method for preparing a polymer solar cell, comprising the steps of:
photoetching an anode conductive substrate, and cleaning the anode conductive substrate to remove impurities on a surface thereof;
forming a hole buffer layer on the photoetched anode conductive substrate by an electron beam technology or a sputtering process, wherein a metal compound is used as a host, a lithium compound is used as a dopant guest, a mass ratio of the dopant guest in the host is in the range of from 1% to 10%; and the metal compound host is made of a material selected from the group consisting of zinc oxide, zinc sulfide, and cadmium sulfide; the dopant guest is made of a material selected from the group consisting of lithium carbonate, lithium oxide, lithium fluoride, lithium chloride, and lithium bromide; and
forming an active polymer layer, an electron buffer layer, and a cathode on the hole buffer layer, sequentially.

8. The method according to claim 7, wherein further comprising:
performing a surface treatment to the cleaned anode conductive substrate using oxygen plasma or UV-ozone.

9. The method according to claim 7, wherein forming the active polymer layer on the hole buffer layer comprises:
coating a polymer solution on the hole buffer layer by spin-coating; and
drying the polymer solution to form the active polymer layer,
wherein a solute of the polymer solution is selected from the group consisting of a mixture of P3HT and PCBM, a mixture of MODO-PPV and PCBM, and a mixture of MEH-PPV and PCBM; a mass ratio of the P3HT to the PCBM in the mixture of P3HT and PCBM is in the range of from 1:0.8 to 1:1, a mass ratio of the MODO-PPV to the PCBM in the mixture of MODO-PPV and PCBM is in the range of from 1:1 to 1:4, a mass ratio of the MEH-PPV to the PCBM in the mixture of MEH-PPV and PCBM is in the range of from 1:1 to 1:4;
a solvent of the polymer solution is selected from the group consisting of toluene, xylene, chlorobenzene, and chloroform; a concentration of the solute in the polymer solution is in the range of from 8mg/mL to 30mg/mL.

10. The method according to claim 7, wherein forming the electron buffer layer on the active polymer layer comprises: depositing a material selected from the group consisting of lithium fluoride, cesium fluoride, and cesium carbonate on the active polymer layer by a magnetron sputtering process or an evaporation process; and
forming the cathode on the electron buffer layer comprises: depositing a material selected from the group consisting of aluminum, silver, gold, and platinum on the electron buffer layer by a magnetron sputtering process or an evaporation process.
